# EUROPEAN PATENT APPLICATION

(11) **EP 1 184 869 A2**
(43) Date of publication of application: **06.03.2002**
(21) Application number: 01116243.5
(22) Date of filing: 04.07.2001
(51) Int. Cl.: G11C 8/04

(54) **Data storage device and data storing method**

(30) Priority: 27.07.2000 JP 2000227349
(71) Applicant: SONY CORPORATION, Tokyo (JP)
(72) Inventor: Tomita, Yoshinori, Shinagawa-ku, Tokyo (JP)
(74) Representative: Müller . Hoffmann & Partner Patentanwälte

(57) **Abstract**

Disclosed is a data storage device which comprises: a plurality of storing means for storing data; writing means for writing data to any of the storing means; reading means for reading data from any of the storing means; and addressing means which, when data are to be either written by the writing means or read by the reading means, addresses the storing means in desired increments by use of a unique address.

## Description

### BACKGROUND OF THE INVENTION

The present invention relates to a data storage device and a data storing method whereby data are illustratively written to and read from storing means.

The smallest piece of data "1" or "0" is stored electrically or magnetically into what is known as a storage cell of one bit. It is customary to call every eight bits one byte that is used as the unit by which data are read and written. Neumann type computers generally assign an address to each byte of their storage so that data are addressed in units of bytes for storage and retrieval thereto and therefrom.

When a specific storage cell (of 1 bit) is to be accessed in the Neumann computer setup above, any one-byte data item that includes the specific bit in question have seven other storage cells (7 bits) being of the same value each. That is because all storage cells are arranged always in the byte-based structure.

Illustratively, where image data with each byte representing a pixel are to be stored into an ordinary storage device, it is customary to write the image data to addresses in ascending order so that the image address is incremented by "1" every time another scanning line is reached. In this case, the bytes each making up a pixel at the ascending-order addresses are "sliced" two-dimensionally through a specific bit location for what is known as bit plane processing. For example, image data may be sliced through, say, a fifth-bit location for each pixel as follows: the data are read from their respective addresses one byte at a time. The fifth-bit data item is retrieved from each of the bytes thus read. The retrieved data items are accumulated in a separate buffer until a predetermined level of data quantity is reached. Once the suitable data level is reached, a specific process is carried out using the data.

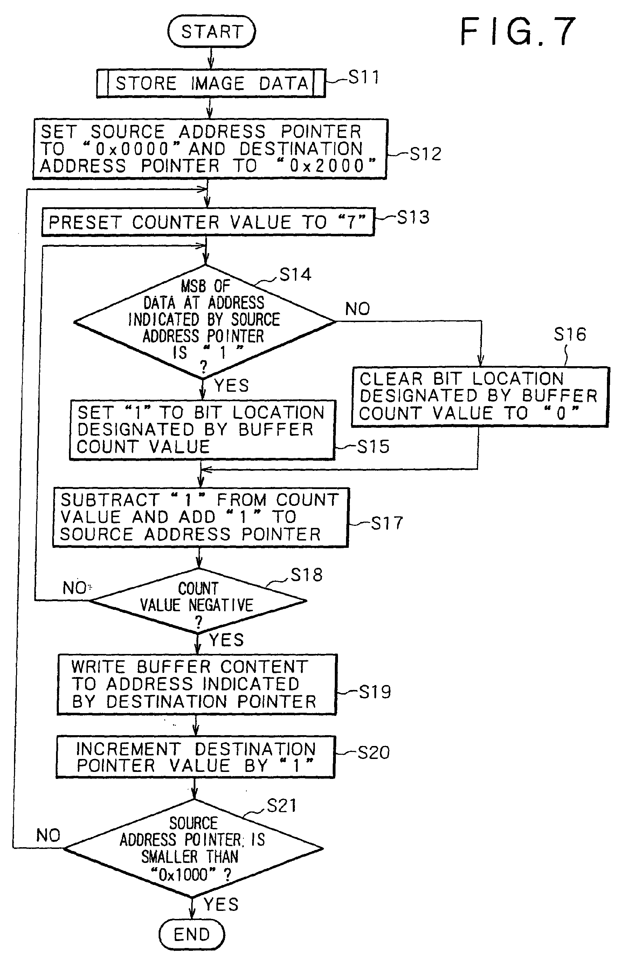

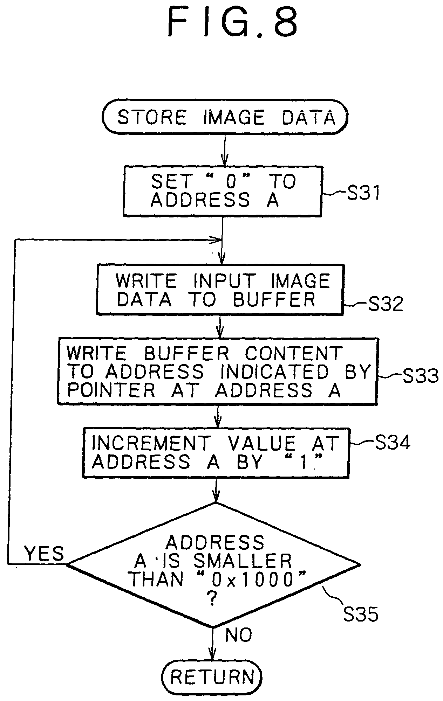

Fig. 7 is a flowchart of steps for conventionally transferring image data for storage. In step S11 of Fig. 7, image data are stored by a subroutine for image data storage. Fig. 8 is a flowchart of detailed steps constituting the image data storing subroutine. In step S31 of Fig. 8, a "0" is set to address A. In step S32, input image data are written to a buffer. In step S33, the buffer content is written to an address pointed to by a pointer at address A. In step S34, the value at address A is incremented by "1." In step S35, a check is made to see if the pointer at address A is smaller than "0x1000." If in step S35 the pointer at address A is judged smaller than "0x1000," step S32 is reached again, and steps S32 through S35 are repeated. If in step S35 the pointer at address A is judged equal to "0x1000," then control is returned.

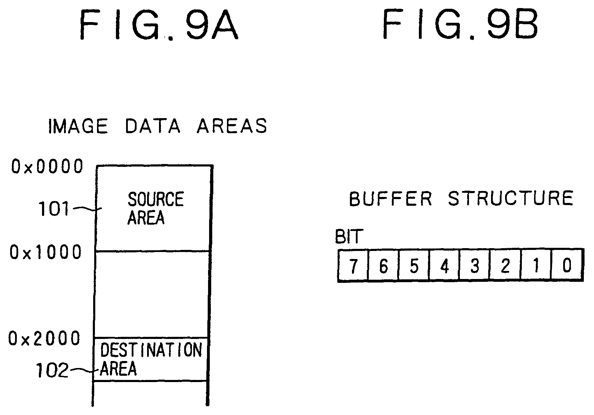

In step S12 back in Fig. 7, a source address pointer is set to "0x0000" and a destination address pointer to "0x2000." Fig. 9A is a schematic view of an image data area. In Fig. 9A, a source area 101 ranges from "0x0000" to "0x1000" and a destination area 102 from "0x2000" to an indefinite location.

In step S13, a counter value is preset to "7." In step S14, a check is made to see if the most significant bit (MSB) of the data at the address pointed to by the source address pointer is "1."

If in step S14 the MSB is judged to be "1" in the data held at the address pointed to by the source address pointer, step S15 is reached. In step S15, a "1" is set to a bit location designated by a buffer count value. Step S15 is followed by step S17. Fig. 9B is a schematic view of a typical buffer structure.

If in step S14 the MSB is not judged to be "1" in the data held at the address specified by the source address pointer, then step S16 is reached in which the bit location designated by the buffer count value is cleared to "0." Step S16 is followed by step S17.

In step S17, a "1" is subtracted from the count value and a "1" is added to the value designated by the source address pointer. In step S18, a check is made to see if the count value is negative. If in step S18 the count value is judged negative, step S19 is reached. If the count value is not found negative in step S18, step S14 is reached again, and steps S14 through S18 are repeated.

In step S19, the buffer content is written to the address pointed to by the destination pointer. In step S20, the destination pointer value is incremented by "1." In step S21, a check is made to see if the source address pointer is smaller than "0x1000." If in step S21 the source address pointer is not judged to be smaller than "0x1000," then step S13 is reached again and steps S13 through S21 are repeated. If the source address pointer is judged smaller than "0x1000" in step S21, the processing is terminated.

There is a major disadvantage to the above-described conventional bit plane processing performed on a specific bit location in each of the pixel bytes making up image data: it takes time. As outlined above, the data are read from their addresses one byte at a time. The data item is retrieved from the desired location in each of the bytes thus read. The retrieved data items are accumulated in a separate buffer. When a predetermined data level is reached in the buffer, a specific process is carried out using the data. The steps involved for transferring the data are time-consuming and inefficient in terms of data access.

### SUMMARY OF THE INVENTION

The present invention has been made in view of the above circumstances and provides a data storage device and a data storing method such that means and steps for data transfer for storage are simplified in order to achieve efficient data access.

In carrying out the invention and according to one aspect thereof, there is provided a data storage device comprising: a plurality of storing means for storing data; writing means for writing data to any of the storing means; reading means for reading data from any of the storing means; and addressing means which, when data are to be either written by the writing means or read by the reading means, addresses the storing meanss in desired increments by use of a unique address.

The inventive device of the above structure works as follows: the addressing means inputs an address while data input means enters input data making up a word, i.e., the smallest increment of data. The writing means writes the input data to one of the storing means which is selected by the address; the reading means reads the data from the storing means selected by the address. This permits outputting of the data constituting the smallest increment (i.e., word).

According to another aspect of the invention, there is provided a data storing method for transferring data from source addresses to destination addresses for storage, the method comprising the steps of: temporarily storing all input data; successively retrieving out of the input data only those data items corresponding to addresses picked in desired increments; and successively transferring the retrieved data items from the source addresses to the destination addresses for storage.

The inventive method of the above constitution provides the following operations: out of temporarily input image data, the data are retrieved from source addresses picked in desired increments. The image data thus read are written unmodified to destination addresses. In this manner, out of all input image data, only those data items in desired increments are directly written to or read from the relevant addresses.

The above and other objects, features and advantages of the present invention will become apparent from the following description and the appended claims, taken in conjunction with the accompanying drawings in which like parts or elements denoted by like reference symbols.

### BRIEF DESCRIPTION OF THE DRAWINGS

Fig. 1 is a circuit diagram of a data storage device in a two-bit structure embodying the invention;
Fig. 2 is a tabular view of correspondence between addresses and storage cell numbers;
Fig. 3 is a schematic view of a black-and-white sample image;
Fig. 4 is a schematic view showing how words are differently organized;
Fig. 5 is a conceptual view of address spaces;
Fig. 6 is a flowchart of steps for storing image data into another area;
Fig. 7 is a flowchart of steps for transferring image data conventionally;
Fig. 8 is a flowchart of steps for storing image data; and
Figs. 9A and 9B are schematic views showing image data areas and a buffer structure respectively.

### DESCRIPTION OF THE PREFERRED EMBODIMENTS

A data storage device according to the invention has addressing means that addresses storage cells in desired increments by use of a unique address. The addressing means may have a plurality of organizing methods for organizing the storage cells into increments for collective addressing. Each of the organizing methods causes the storage cells to be addressed in desired increments by use of another unique address; the desired increments may include the same storage cell.

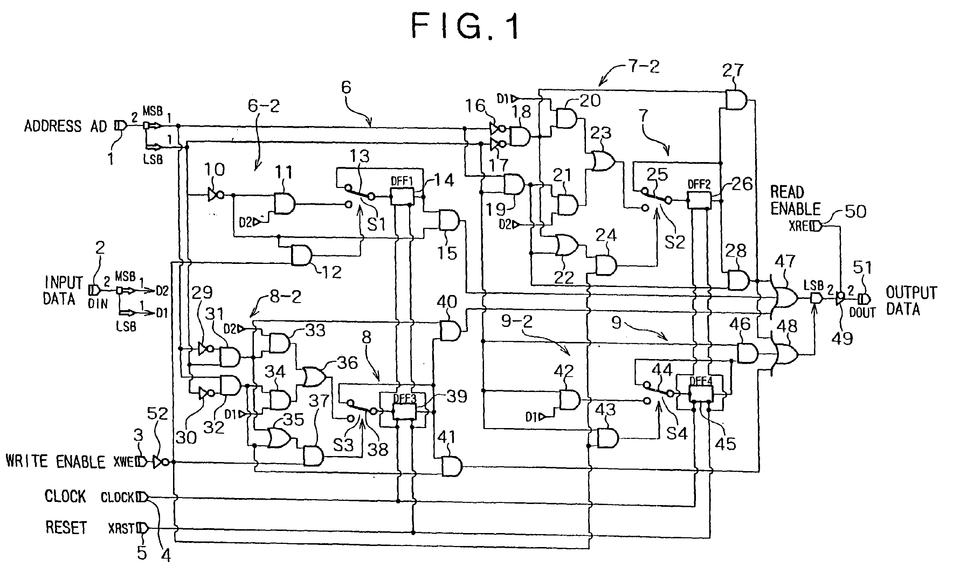

Fig. 1 is a circuit diagram of a data storage device in a two-bit structure embodying the invention. Fig. 1 indicates a typical two-bit hardware setup simplified for purpose of simplification and illustration.

In Fig. 1, a two-bit address AD is input through a terminal 1, one-word two-bit input data DIN through a terminal 2, a write enable signal XWE through a terminal 3, a clock signal CLOCK through a terminal 4, and a reset signal XRST through a terminal 5. A read enable signal XRE is input through a terminal 50, and one-word two-bit output data DOUT are output through a terminal 51.

The data storage device of Fig. 1 comprises a storage cell 1 (6) with a logic circuit 6-2, a storage cell 2 (7) with a logic circuit 7-2, a storage cell 3 (8) with a logic circuit 8-2, a storage cell 4 (9) with a logic circuit 9-2, an inverter 52, OR circuits 47 and 48, and a three-state buffer 49.

The storage cell 1 (6) includes a switch (S1) 13 and a flip-flop (DFF1) 14. The logic circuit 6-2 is located upstream of the storage cell 1 (6). The logic circuit 6-2 includes an inverter 10 as well as AND circuits 11, 12 and 15.

An LSB side of the terminal 1 through which the address AD is input is connected to the input of the inverter 10 in the logic circuit 6-2. The output of the inverter 10 is connected to one input of the AND circuit 11; the other input of the AND circuit 11 is connected to an MSB side (D2) of the terminal 2 through which the input data DIN are input.

The output of the AND circuit 11 is connected to a fixed contact on one side of the switch (S1) 13; a moving contact of the switch (S1) 13 is connected to the input of the flip-flop (DFF1) 14. The output of the flip-flop (DFF1) 14 is connected to a fixed contact on the other side of the switch S(1) 13. The output of the flip-flop (DFF1) 14 is also connected to one input of the AND circuit 15; the other input of the AND circuit 15 is connected to the output of the inverter 10. The output of the AND circuit 15 is connected to one of three inputs of the OR circuit 47.

The terminal 3 through which the write enable signal XWE is input is connected to the input of the inverter 52. The output of the inverter 52 is connected to one input of the AND circuit 12; the other input of the AND circuit 12 is connected to the output of the inverter 10. The output of the AND circuit 12 is connected to a moving contact switching control terminal of the switch (S1) 13.

The terminal 4 through which the clock signal CLOCK is input is connected to a clock terminal of the flip-flop (DFF1) 14. The terminal 5 through which the reset signal XRST is input is connected to a reset terminal of the flip-flop (DFF1) 14.

The storage cell 2 (7) has a switch (S2) 25 and a flip-flop (DFF2) 26. The logic circuit 7-2, located upstream of the memory cell 2 (7), comprises inverters 16 and 17, AND circuits 18; 19, 20, 21, 24, 27 and 28; and OR circuits 22 and 23.

An MSB side of the terminal 1 through which the address AD is input is connected to the input of the inverter 16 in the logic circuit 7-2. The output of the inverter 16 is connected to one input of the AND circuit 18. The LSB side of the terminal 1 through which the address AD is input is connected to the input of the inverter 17. The output of the inverter 17 is connected to the other input of the AND circuit 18.

The output of the AND circuit 18 is connected to one input of the AND circuit 20; the other input of the AND circuit 20 is connected to an LSB side (D1) of the terminal 2 through which the input data DIN is input. The MSB side of the terminal 1 through which the address AD is input is connected to one input of the AND circuit 19. The LSB side of the terminal 1 through which the address AD is input is connected to the other input of the AND circuit 19. The output of the AND circuit 19 is connected to one input of the AND circuit 21; the other input of the AND circuit 21 is connected to the MSB side (D2) of the terminal 2 through which the input data DIN are input. The output of the AND circuit 20 is connected to one input of the OR circuit 23. The output of the AND circuit 21 is connected to the other input of the OR circuit 23.

The output of the OR circuit 23 is connected to one fixed contact of the switch (S2) 25. A moving contact of the switch (S2) 25 is connected to the input of the flip-flop (DFF2) 26. The output of the flip-flop (DFF2) 26 is connected to the other fixed contact of the switch (S2) 25. The output of the flip-flop (DFF2) is connected to one input of the AND circuit 28; the other input of the AND circuit 28 is connected to the output of the AND circuit 19.

The output of the AND circuit 18 is connected to one input of the OR circuit 22. The output of the AND circuit 19 is connected to the other input of the OR circuit 22.

The terminal 3 through which the write enable signal XWE is input is connected to the input of the inverter 52. The output of the inverter 52 is connected to one input of the AND circuit 24; the other input of the AND circuit 24 is connected to the output of the OR circuit 22. The output of the AND circuit 24 is connected to a moving contact switching control terminal of the switch (S2) 25.

The output of the AND circuit 18 is connected to one input of the AND circuit 27; the other input of the AND circuit 27 is connected to the output of the flip-flop (DFF2) 26. The output of the AND circuit 27 is connected to the output of the AND circuit 28. The output of the AND circuit 28 is connected to one of three inputs of the OR circuit 47.

The terminal 4 through which the clock signal CLOCK is input is connected to a clock terminal of the flip-flop (DFF2) 26. The terminal 5 through which the reset signal XRST is input is connected to a reset terminal of the flip-flop (DFF2) 26.

The storage cell 3 (8) is made up of a switch (S3) 38 and a flip-flop (DFF3) 39. The logic circuit 8-2, located upstream of the memory cell 3 (8), comprises inverters 29 and 30, AND circuits 31, 32, 33, 34, 37, 40 and 41; and OR circuits 35 and 36.

The MSB side of the terminal 1 through which the address AD is input is connected to the input of the inverter 29 in the logic circuit 8-2. The output of the inverter 29 is connected to one input of the AND circuit 31. The LSB side of the terminal 1 through which the address AD is input is connected to the other input of the AND circuit 31.

The output of the AND circuit 31 is connected to one input of the AND circuit 33; the other input of the AND circuit 33 is connected to the MSB side (D2) of the terminal 2 through which the input data DIN are input. The MSB side of the terminal 1 through which the address AD is input is connected to one input of the AND circuit 32. The LSB side of the terminal 1 through which the address AD is input is connected to the input of the inverter 30. The output of the inverter 30 is connected to the other input of the AND circuit 32. The output of the AND circuit 32 is connected to one input of the AND circuit 34; the other input of the AND circuit 34 is connected to the LSB side (D1) of the terminal 2 through which the input data DIN are input. The output of the AND circuit 33 is connected to one input of the OR circuit 36. The output of the AND circuit 34 is connected to the other input of the OR circuit 36.

The output of the OR circuit 36 is connected to one fixed contact of the switch (S3) 38. A moving contact of the switch (S3) 38 is connected to the input of the flip-flop (DFF3) 39. The output of the flip-flop (DFF3) 39 is connected to another fixed contact of the switch (S3) 38. The output of the flip-flop (DFF3) 39 is connected to one input of the AND circuit 41; the other input of the AND circuit 41 is connected to the output of the AND circuit 32.

The output of the AND circuit 31 is connected to one input of the OR circuit 35. The output of the AND circuit 32 is connected to the other input of the OR circuit 35.

The terminal 3 through which the write enable signal XWE is input is connected to the input of the inverter 52. The output of the inverter 52 is connected to one input of the AND circuit 37; the other input of the AND circuit 37 is connected to the output of the OR circuit 35. The output of the AND circuit 37 is connected to a moving contact switching control terminal of the switch (S3) 38.

The output of the AND circuit 31 is connected to one input of the AND circuit 40; the other input of the AND circuit 40 is connected to the output of the flip-flop (DFF3) 39. The output of the AND circuit 40 is connected to one of three inputs of the OR circuit 47. The output of the AND circuit 41 is connected to one of three inputs of the OR circuit 48.

The terminal 4 through which the clock signal CLOCK is input is connected to a clock terminal of the flip-flop (DFF3) 39. The terminal 5 through which the reset signal XRST is input is connected to a reset terminal of the flip-flop (DFF3) 39.

The storage cell 4 (9) is constituted by a switch (S4) 44 and a flip-flop (DFF4) 45. The logic circuit 9-2, located upstream of the storage cell 4 (9), comprises AND circuits 42, 43 and 46.

The LSB side of the terminal 1 through which the address AD is input is connected to one input of the AND circuit 42 in the logic circuit 9-2. The other input of the AND circuit 42 is connected to the LSB side (D1) of the terminal 2 through which the input data DIN are input.

The output of the AND circuit 42 is connected to one fixed contact of the switch (S4) 44. A moving contact of the switch (S4) 44 is connected to the input of the flip-flop (DFF4) 45. The output of the flip-flop (DFF4) 45 is connected to another fixed contact of the switch (S4) 44. The output of the flip-flop (DFF4) 45 is connected to one input of the AND circuit 46; the other input of the AND circuit 46 is connected to the LSB side of the terminal 1 through which the address AD is input. The output of the AND circuit 46 is connected to one of three inputs of the OR circuit 48.

The terminal 3 through which the write enable signal XWE is input is connected to the input of the inverter 52. The output of the inverter 52 is connected to one input of the AND circuit 43; the other input of the AND circuit 43 is connected to the LSB side of the terminal 1 through which the address AD is input. The output of the AND circuit 43 is connected to a moving contact switching control terminal of the switch (S4) 44.

A two-bit output composed of the outputs from the OR circuits 47 and 48 is connected to the input of the three-state buffer 49. The terminal 50 through which the read enable signal XRE is input is connected to a gate of the three-state buffer 49. The output of the three-state buffer 49 is connected to the terminal 51 through which one-word two-bit output data DOUT are output.

The terminal 4 through which the clock signal CLOCK is input is connected to a clock terminal of the flip-flop (DFF4) 45. The terminal 5 through which the reset signal XRST is input is connected to a reset terminal of the flip-flop (DFF4) 45.

The data storage device structured as described above operates as follows: a two-bit address AD is input through the terminal 1, and one-word two-bit input data DIN are entered through the terminal 2. Setting to "0" the write enable signal XWE input through the terminal 3 causes the input data DIN to be written to two of the storage cells 1 (6), 2 (7), 3 (8) and 4 (9), the two cells being selected by the address AD. Setting to "0" the read enable signal XRE input through the terminal 50 causes data to be read from two of the storage cells 1 (6), 2 (7), 3 (8) and 4 (9), the two cells being selected by the address AD. The retrieved data are output from the three-state buffer 49 and through the terminal 51, constituting one-word two-bit output data DOUT.

The switch (S1) 13 and flip-flop (DFF1) 14 constitute the one-bit storage cell 1 (6) to and from which a data item is written or read. The switch (S2) 25 and flip-flop (DFF2) 26 make up the one-bit storage cell 2 (7) having one-bit data written thereto or read therefrom. The switch (S3) 38 and flip-flop (DFF3) 39 form the one-bit storage cell 3 (8) subject to a one-bit data write or read operation. The switch (S4) 44 and flip-flop (DFF4) 45 compose the one-bit storage cell 4 (9) on which a one-bit data write or read operation is performed.

When a "1" is input to the moving contact switching control terminal of the switch (S1) 13, the moving contact of the switch (S1) 13 is connected to one of its fixed contacts, and input data are written by the flip-flop (DFF1) 14 to that fixed contact of the switch (S1) 13. When a "0" is input to the moving contact switching control terminal of the switch (S1) 13, the moving contact of the switch (S1) 13 is connected to another of its fixed contacts, and the data written by the flip-flop (DFF1) 14 are retained there.

When a "1" is input to the moving contact switching control terminal of the switch (S2) 25, the moving contact of the switch (S2) 25 is connected to one of its fixed contacts, and input data are written by the flip-flop (DFF2) 26 to that fixed contact of the switch (S2) 25. When a "0" is input to the moving contact switching control terminal of the switch (S2) 25, the moving contact of the switch (S2) 25 is connected to another of its fixed contacts, and the data written by the flip-flop (DFF2) 26 are retained there.

When a "1" is input to the moving contact switching control terminal of the switch (S3) 38, the moving contact of the switch (S3) 38 is connected to one of its fixed contacts, and input data are written by the flip-flop (DFF3) 39 to that fixed contact of the switch (S3) 38. When a "0" is input to the moving contact switching control terminal of the switch (S3) 38, the moving contact of the switch (S3) 38 is connected to another of its fixed contacts, and the data written by the flip-flop (DFF3) 39 are retained there.

When a "1" is input to the moving contact switching control terminal of the'switch (S4) 44, the moving contact of the switch (S4) 44 is connected to one of its fixed contacts, and input data are written by the flip-flop (DFF4) 45 to that fixed contact of the switch (S4) 44. When a "0" is input to the moving contact switching control terminal of the switch (S4) 44, the moving contact of the switch (S4) 44 is connected to another of its fixed contacts, and the data written by the flip-flop (DFF4) 45 are retained there.

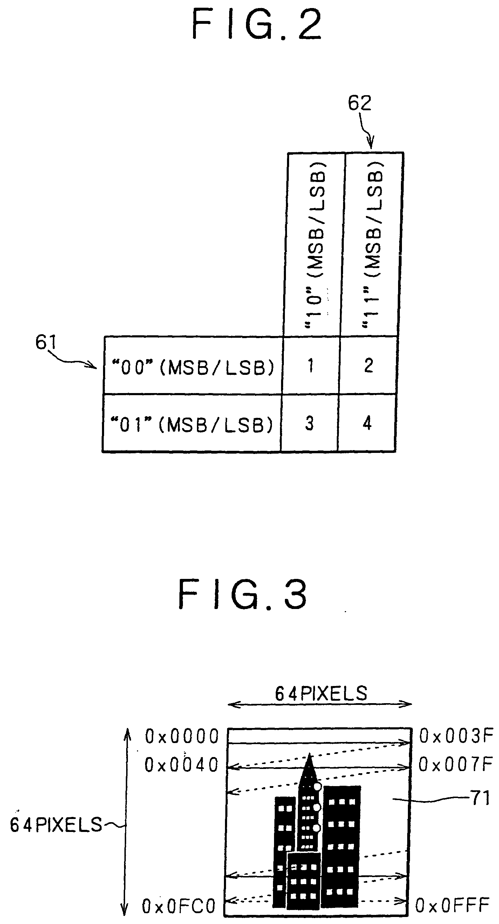

Fig. 2 is a tabular view of correspondence between addresses and storage cell numbers. As shown in Fig. 2, the combination of two corresponding storage cells varies depending on whether the MSB value of the address AD is "0" or "1."

In Fig. 2, reference numeral 61 indicates that when the MSB is "0" and the LSB is also "0" in the address AD, the storage cells (1) and (2) correspond to each other; when the MSB is "0" and the LSB is "1" in the address AD, then the storage cells (3) and (4) correspond to each other.

Reference numeral 62 in Fig. 2 indicates that when the MSB is "1" and the LSB is "0" in the address AD, the storage cells (1) and (3) correspond to each other; when the MSB is "1" and the LSB is also "1" in the address AD, then the storage cells (2) and (4) correspond to each other.

As described, the correspondence table of Fig. 2 shows possible two-bit combinations of the memory cells (1) through (4) to and from which data may be written and read.

What follows is an example showing how the data format is extended to eight bits and how actual image data are accessed. Fig. 3 is a schematic view of a black-and-white sample image. The sample image 71 in Fig. 3 is made up of 64 x 64 pixels, each pixel being represented by eight bits.

Suppose that the 64-by-64-pixel black-and-white sample image 71 in Fig. 3 is to be stored into memory in the order of scanning lines. If the start pixel has address "0x0000," then the address to which the immediately right-hand pixel is set is given by incrementing the current address by "1." The address to which the pixel immediately below the current pixel is set is higher by "0x0040" than the current address.

Because the data representing all 64 by 64 pixels in the black-and-white sample image 71 amount to "0x1000 (= 64 x 64)", the data representative of the last pixel are set to address "0x0FFF."

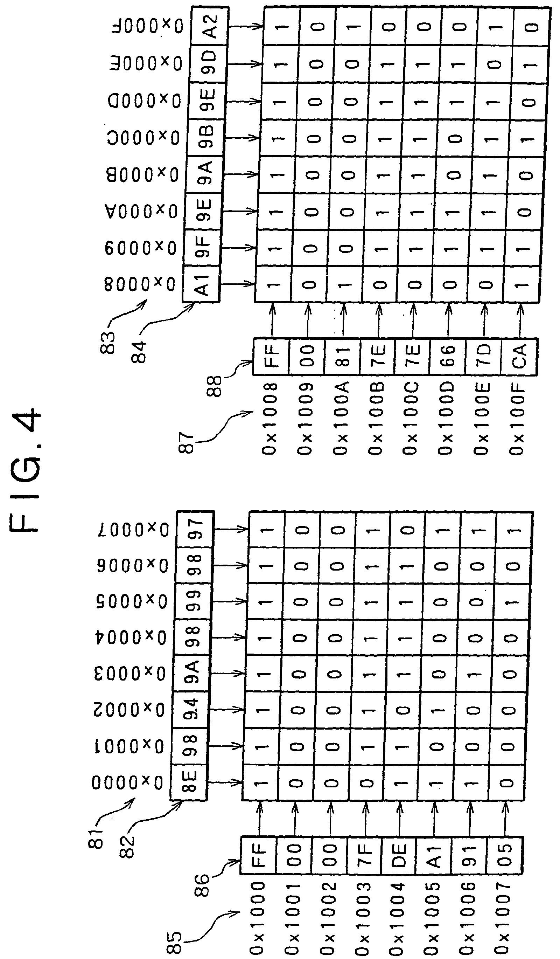

Fig. 4 schematically shows how words are differently organized. Fig. 4 provides a two-dimensional view of pixel data being deployed in storage cells. Although the view in Fig. 4 indicates addresses only up to "0x000F" for space reasons, the same arrangement applies up to the last pixel data at address "0x0FFF."

In Fig. 4, there are two methods for organizing words. By one method, each byte is organized in eight bits per pixel constituting words at addresses "0x0000" through "0x000F" in the horizontal direction as indicated by reference numerals 81 and 83. By another method, each eight-bit word is organized per pixel through bit plane division at addresses "0x1000" through "0x100F" in the vertical direction as indicated by reference numerals 85 and 87.

In the above arrangement of addresses "0x1000" through "0x100F" in the vertical direction as indicated by reference numerals 85 and 87, the MSB location "FF" may be accessed illustratively for data access per bit plane.

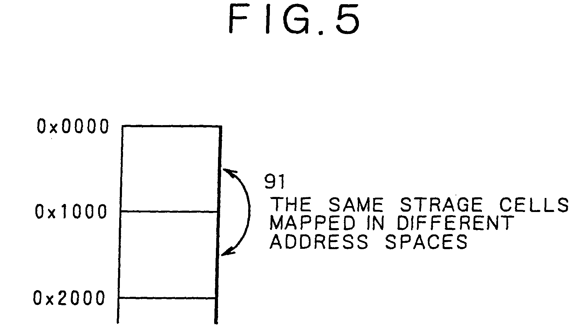

In such a case, as shown in the conceptual view of address spaces in Fig. 5, the data at addresses "0x0000" through "0x0FFF" and at addresses "0x1000" through "0x1FFF" may be mapped into different address spaces although they are constituted by the same storage cells, as indicated by reference numeral 91.

The way words are organized thus varies depending on whether any of addresses "0x0000" through "0x0FFF" is accessed or any of addresses "0x1000" through "0x1FFF" is accessed.

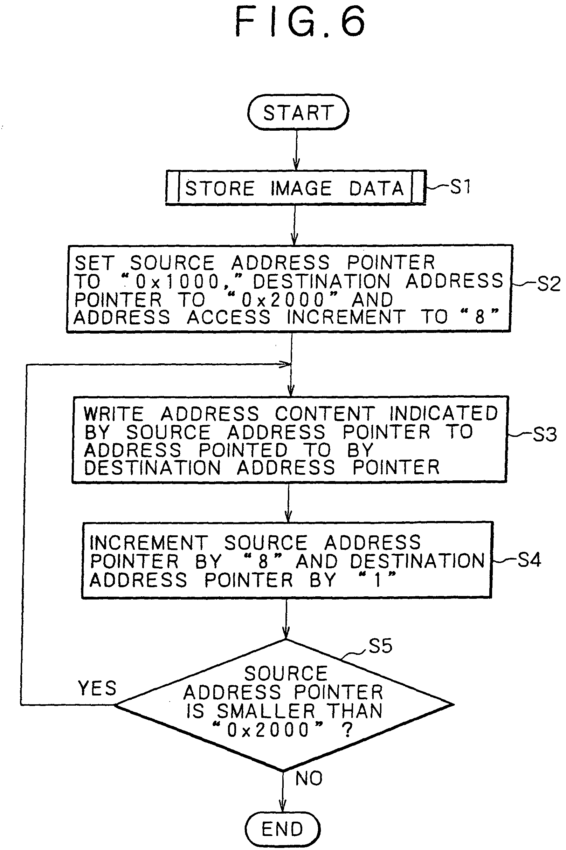

Fig. 6 is a flowchart of steps for storing image data into a different area. In this example, as shown in Figs. 9A and 9B, the MSB data alone are accessed through bit plane division from the pixel data in a source area 101 ranging from address "0x0000" to address "0x0FFF" of the 64-by-64-pixel black-and-white sample image. The retrieved MSB data are transferred to a destination area 102 starting from address "0x2000."

In step S1 of Fig. 6, the image data are stored. The storing operation is carried out by resorting to the image data storing subroutine discussed earlier with reference to Fig. 8.

In step S2, the source address pointer is set to "0x0000" and the destination address pointer to "0x2000." The address access increment is set to "8."

In step S3, the address content pointed to by the source address pointer is written to the address pointed to by the destination address pointer.

In step S4, the source address pointer is incremented by "8" and the destination address pointer by "1."

In step S5, a check is made to see if the source address pointer is smaller than "0x2000." If in step S5 the source address pointer is judged smaller than "0x2000," step S3 is reached again and steps S3 through S5 are repeated. If in step S5 the source address pointer is found equal to "0x2000," the processing is terminated.

Conventionally, one-bit data are extracted out of all the 4,096 bytes of image data that have been read, until one byte of data is accumulated in a buffer. Every time one-byte data have been amassed, they are written to a destination address. According to the invention, by contrast, image data are read from every eighth address and the retrieved data are written directly to destination addresses. That means 512 bytes of data need only be read and written directly before the processing is terminated.

It follows that the inventive device and method permit transferring theoretically eight times the amount of data transferred conventionally. Because there is no need for bit-by-bit extraction and buffering processes, the efficiency of data transfer is enhanced more then eightfold.

Although two-bit and eight-bit data arrangements have been discussed above as examples, these are not limitative of the invention. It is obvious that the invention is also applied advantageously to 16-bit and 32-bit data setups.

Although the storage cells of the data storage device in Fig. 1 were shown constituted by flip-flops, this is not limitative of the invention. Alternatively, SRAMs (static random access memories), SDRAMs (synchronous dynamic random access memories) or flash memories may also be used as storage cells.

While a preferred embodiment of the present invention has been described using specific terms, such description is for illustrative purposes only, and it is to be understood that changes and variations may be made without departing from the spirit or scope of the following claims.

## Claims

1. A data storage device comprising:
a plurality of storing means for storing data;
writing means for writing data to any of said storing means;
reading means for reading data from any of said storing means; and
addressing means which, when data are to be either written by said writing means or read by said reading means, addresses said storing means in desired increments by use of a unique address.

2. A data storage device according to claim 1, wherein said addressing means has a plurality of organizing methods for organizing said storing means into increments for collective addressing, each of the methods causing said storing means to be addressed in desired increments by use of another unique address, (said desired increments including the same storing means.)

3. A data storage device according to claim 2, wherein said data are image data, and wherein said organizing methods include a method for organizing one-byte data in increments of pixels, and a method for organizing one-byte data by dividing the pixel-by-pixel one-byte data into desired increments of bits.

4. A data storage device according to claim 1, wherein said addressing means maps the same storing means in different address spaces.

5. A data storing method for transferring data from source addresses to destination addresses for storage, the method comprising the steps of:
temporarily storing all input data;
successively retrieving out of said input data only those data items corresponding to addresses picked in desired increments; and
successively transferring the retrieved data items from said source addresses to said destination addresses for storage.
